# EUROPÄISCHE PATENTSCHRIFT

(11) **EP 0 806 827 B1**
(45) Veröffentlichungstag und Bekanntmachung des Hinweises auf die Patenterteilung: **22.04.1998**
(21) Anmeldenummer: 96107376.4
(22) Anmeldetag: 09.05.1996
(51) Int. Cl.: H02H 11/00, H03K 17/06

(54) **Verpolschutz-Schaltungsanordnung**
Reverse battery protection circuit
Circuit de protection contre l'inversion des bornes de la batterie

(43) Veröffentlichungstag der Anmeldung: 12.11.1997
(73) Patentinhaber: SIEMENS AKTIENGESELLSCHAFT, 80333 München (DE)
(72) Erfinder: Dietz, Armin, 97276 Margetshöchheim (DE); Johanning, Hans-Peter, 60489 Frankfurt (DE)

(56) Entgegenhaltungen:
- EP-A- 0 626 745
- US-A- 4 423 456
- EDN ELECTRICAL DESIGN NEWS, Bd. 41, Nr. 5, 1.März 1996, Seiten 165-168, 170, 172, XP000584147 DAVIS D: "OVERLOAD AND REVERSE-CURRENT CIRCUITRY PROTECTS BATTERY AND LOAD"

## Beschreibung

Die Erfindung bezieht sich auf eine Verpolschutz-Schaltungsanordnung gemäß Patentanspruch 1.

Aus einer Gleichspannung gespeiste elektrische Geräte und insbesondere elektronische Schaltungen können durch eine Verpolung beschädigt oder sogar zerstört werden; unter einer Verpolung versteht man dabei, daß die Spannungsversorgung durch die Gleichspannung nicht mit der richtigen Polarität an das elektrisch Gerät bzw. die elektronische Schaltung angeschlossen wird. In Kraftfahrzeugen besteht die Gefahr einer Verpolung, insbesondere beim Wechseln bzw. An- bzw. Abklemmen einer Batterie im Rahmen von Reparaturarbeiten durch Verwechseln von Plupol-Anschluß einerseits und Massepol-Anschluß andererseits.

Verpolschutzschaltungen verschiedener Art, jedoch jeweils unter Verwendung von MOSFET-Transistoren sind z.B. durch die EP-A1-0 495 142, die DE-A1-39 90 896 und die DE-A1-40 00 637 bekannt.

Im ersten vorgenannten bekannten Fall ist ein MOSFET-Transistor des p-Kanal-Typs mit seiner Drain-Source-Strecke in die positive Versorgungsleitung zwischen der Versorgungsspannungsquelle und einer elektronischen Schaltung geschaltet;das Gate des MOSFET-Transistors liegt am Bezugspotential der Versorgungsspannungsquelle und somit an negativer Versorgungsleitung bzw. an Masse, d.h. am Karosserie-Masseanschluß bei Einsatz in einem Kraftfahrzeug.

Im zweiten vorgenannten bekannten Fall ist zwischen dem Masseeingang und dem Masseausgang einer Verpolschutzanordnung ein invers betriebener MOSFET-Transistor angeordnet, dessen Gate mit dem Spannungseingang, d.h. der positiven Versorgungsleitung, verbunden ist.

Im letzten vorgenannten bekannten Fall ist ein Verpolschutz mit einem mit einer Substratdiode versehenen invers betriebenen MOSFET-Transistors des n-Kanal-Typs vorgesehen, wobei der eine Pol der elektrischen Einrichtung mit dem Pluspol der Gleichspannungsquelle und der andere Pol der elektrischen Einrichtung mit der Source-Elektrode des Transistors verbunden, dessen Gate-Elektrode an den Pluspol und dessen Drain-Elektrode an den Minuspol der Gleichspannungsquelle angeschlossen ist.

Aus der EP 0 626 745 A2 ist eine Schaltungsanordnung mit einem in einer positiven Versorgungsleitung einer Gleichspannungsquelle invers betriebenen MOSFET-Transistor vom n-Kanal-Typ bekannt, wobei zur Ansteuerung eine Steuerspannung vorgesehen ist, die höher ist als die speisende Gleichspannung.

Gemäß Aufgabe vorliegender Erfindung soll ein Verpolschutz geschaffen werden, der bei minimalem Schaltungsaufwand und minimaler Verlustleistung sich insbesondere dadurch auszeichnet, daß ein Spannungsabfall in der negativen Versorgungsleitung, d.h. der Masseleitung, vermieden werden kann, was insbesondere zur erhöhten Störsicherheit einer Schaltung, z.B. in Kraftfahrzeugen, führt, deren Ein- bzw. Ausgangssignale auf Masse (Bezugspotential) bezogen sind.

Die Lösung dieser Aufgabe gelingt durch eine Verpolschutz-Schaltungsanordnung gemäß Patentanspruch 1; vorteilhafte Ausgestaltungen der Erfindung sind jeweils Gegenstand der Unteransprüche.

Die erfindungsgemäße Verpolschutz-Schaltungsanordnung erlaubt die Verwendung eines kostengünstigen MOSFET-Transistors des n-Kanal-Typs, der durch seine bisher unübliche Anordnung in der positiven Versorgungsleitung mit Gate-Ansteuerung aus der elektrischen Einrichtung die negative Versorgungsleitung, d.h. die Massezuleitung, von Spannungsabfällen freihält.

Ein zur Ansteuerung des Gate des MOSFET-Transistors notwendiger, gegenüber Source erhöhter Spannungswert ist dabei in aufwandsarmer Weise aus der elektrischen Einrichtung selbst bzw. aus den von ihr angesteuerten weiteren elektrischen Bauteilen in Form von zu- und abgeschalteten induktiven Lasten ohne wesentlichen zusätzlichen Schaltungsaufwand abgeleitet; bei einer Ansteuerelektronik für einen Elektromotor mit z.B. in Form von zur Drehmomentbildung am Stator- bzw. Rotorumfang aufeinanderfolgend zu- und abgeschalteten Rotorwicklungssträngen ist nach einer Ausgestaltung der Erfindung vorgesehen, die erhöhte Gate-Spannung über Dioden aus den Überspannungsspitzen der abgeschalteten, zuvor bestromten Wicklungsstranginduktivitäten abzuleiten.

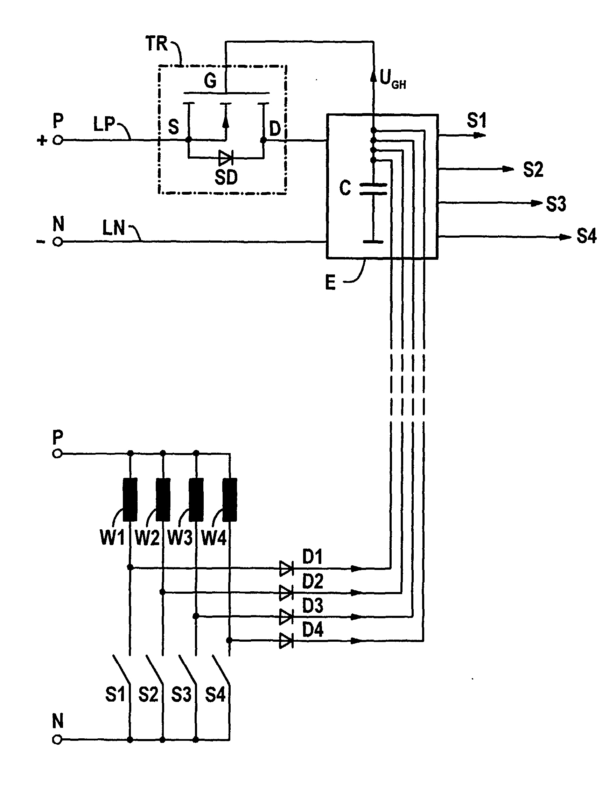

Die Erfindung sowie weitere vorteilhafte Ausgestaltungen der Erfindung gemäß Merkmalen der Unteransprüche werden im folgenden anhand schematisch dargestellter Ausführungsbeispiele in der Zeichnung näher erläutert; diese zeigt den grundsätzlichen Aufbau einer erfindungsgemäßen Verpolschutz-Schaltungsanordnung und einer von dieser z.B. angesteuerten schaltbaren Wicklungsstranganordnung mit einer Ableitung einer erhöhten Gate-Hilfssteuerspannung.

Die Figur zeigt in ihrem oberen Teil einen Verpolschutz für eine aus einer Gleichspannungsquelle P;N über eine positive Versorgungsleitung LP und eine negative Versorgungsleitung LN gespeiste elektrische Einrichtung E, z.B. eine elektronische Steuer- bzw. Regelschaltung in einem Kraftfahrzeug; bei der bevorzugten Anwendung in einem Kraftfahrzeug wird die elektronische Schaltung E aus einer Gleichspannnungsquelle P;N in Form einer Batterie über eine diskrete positive Versorgungsleitung LP angeschlossen und die negative Versorgungsleitung LN als Masseleitung mit jeweils einem Masseanschluß der Batterie und einem Masseanschluß der elektronischen Einrichtung E über die Karosserie geführt.

Als Verpolschutz ist erfindungsgemäß in der positiven Versorgungsleitung LP ein MOSFET-Transistor TR des n-Kanal-Typs mit einer Substratdiode SD derart angeordnet, daß seine Source-Elektrode S mit dem positiven Spannungspol P der Batterie, seine Drain-Elektrode D mit dem positiven Spannungseingang der elektronischen Einrichtung E und seine Gate-Elektrode G an einen Steuerausgang der elektronischen Einrichtung E angeschlossen ist, über die eine erhöhte Gate-Spannung als Hilfssteuerspannung UGH an die Gate-Elektrode G anlegbar ist.

Der Verpolschutz der vorgenannten erfindungsgemäßen Schaltungsanordnung ergibt sich wie folgt: Bei korrekter Polung wird die Substratdiode SD leitend, wodurch die elektronische Einrichtung E zunächst über die Substratdiode SD mit der Gleichspannungsquelle PN verbunden ist. Durch die in der elektronischen Einrichtung E erzeugte und an die Gate-Elektrode G des MOSFET-Transistors TR angelegte Hilfssteuerspannung UGH wird dann der MOSFET-Transistor TR durchgeschaltet, so daß die elektrische Einrichtung E direkt über die Source-Drain-Strecke an die Gleichspannungsquelle PN angelegt ist.

Im Falle einer Falschpolung liegt die Source-Elektrode S am negativen Pol N bzw. an Masse der Gleichspannungsquelle P;N. Aufgrund der nunmehr sperrenden Substratdiode SD ist die elektronische Einrichtung E vor einem Falschanschluß an die Gleichspannungsquelle PN geschützt. Durch geeignete Ansteuerung der Gate-Elektrode G des MOSFET-Transistors TR kann erreicht werden, daß die Hilfssteuerspannung UGH zwischen der Gate-Elektrode G und der Source-Elektrode S klein und somit der MOSFET-Transistor TR gesperrt bleibt.

Durch die unmittelbare, von einer Zwischenschaltung von elektronischen Bauelementen freie, Masseverbindung zwischen der Gleichspannungsquelle P;N einerseits und der elektrischen Einrichtung E andererseits ist eine von Spannungsabfällen freie Masseleitung und durch das direkte Durchschalten der Spannungsversorgung über die Source-Drain-Strecke des MOSFET-Transistors TR ohne Stromzweige über verlustreiche Dioden ist eine Minimierung der gesamten Verlustleistung jeweils gewährleistet.

Der untere Teil der Figur zeigt ein erfindungsgemäßes Ausführungsbeispiel zur vorteilhaften Ableitung der erhöhten Hilfssteuerspannung U_{GH} aus einer an sich vorhandenen Spannungsquelle. Dazu wird davon ausgegangen, daß die elektrische Einrichtung E u.a. dazu dient, über den Umfang eines Elektromotors verteilte Motorwicklungsstränge W1-W4 sukzessive im Sinne einer Drehmomentenbildung über Wicklungsschalter S1-S4 einzuschalten und damit die Motowicklungsstränge an die Gleichspannungsquelle P;N anzuschließen bzw. durch anschließendes Ausschalten wieder von der Gleichspannungsquelle P;N abzutrennen. Aus den in bekannter Weise bei Abschalten einer induktiven Last, z.B. in Form der Motorwicklungssträngen W1-W4, entstehenden Spannungsspitzen wird in vorteilhafter Weise die gegenüber der Source-Elektrode S erhöhte Steuerhilfsspannung U_{GH} für die Gate-Elektrode des MOSFET-Transistors TR abgeleitet; dazu werden die Spannungspitzen über Dioden D1-D4 aus den Motorwicklungssträngen W1-W4 ausgekoppelt und über einen als Spitzenwertspeicher vorgesehenen Kondensator in der elektronischen Einrichtung E zur Bildung der erhöhten Hilfssteuerspannung U_{GH} genutzt. Bei entsprechender Dimensionierung fällt die Spannung am Kondensator C zwischen den einzelnen Überspannungsspitzen nur soweit ab, daß bei jedem neuen Schaltvorgang der Kondensator C hinreichend nachgeladen ist.

## Patentansprüche

1. Verpolschutz-Schaltungsanordnung für eine an eine Gleichspannungsquelle (P:N) über eine positive Versorgungsleitung (LP) und eine negative Versorgungsleitung (LN) anschließbare elektrische Einrichtung (E) mittels eines invers betriebenen MOSFET-Trasistors (TR) vom n-Kanal-Typ, der in der positiven Versorgungsleitung (LP) angeordnet und im Fall einer korrekten Polung von der zunächst über die Inversdiode des MOSFET-Transistors (TR) an die Gleichspannungsquelle (P;N) angeschlossenen elektrischen Einrichtung (E) mittels einer an seine Gate-Elektrode (G) abgegebenen Hilfssteuerspannung (U_{GH}) durchsteuerbar ist, die von einer von der elektrischen Einrichtung (E) zu- und abgeschalteten induktiven Last und einer aus den Überspannungsspitzen der abgeschalteten induktiven Last abgeleitetet ist.

2. Verpolschutz-Schaltungsanordnung nach Anspruch 1 mit von der elektrischen Einrichtung (E) an eine Gleichspannungsquelle (P;N) zugeschalteten und von dieser abgeschalteten Motorwicklungen (W1-W4) und aus diesen bei ihrer Abschaltung ausgekoppelten induktiven Überspannungsspitzen.

3. Verpolschutz-Schaltungsanordnung nach zumindest einem der vorhergehenden Ansprüche mit einer Parallelschaltung von mehr als einem MOSFET-Transistor (TR) in der positiven Versorgungsleitung (LP).

## Claims

1. Polarity reversal protection circuit arrangement for an electrical device (E), which can be connected to a DC voltage source (P;N) via a positive supply lead (LP) and a negative supply lead (LN), by means of an inversely operated MOSFET transistor (TR) of the n-channel type which is arranged in the positive supply lead (LP) and, in the case of correct polarity, can be driven by the electrical device (E), which is initially connected to the DC voltage source (P;N) via the inverse diode of the MOSFET transistor (TR), by means of an auxiliary control voltage (U_{GH}) which is output to the gate electrode (G) of the said MOSFET transistor and is derived from an inductive load, which is connected up and disconnected by the electrical device (E), and/or from the overvoltage spikes of the disconnected inductive load.

2. Polarity reversal protection circuit arrangement according to Claim 1, having motor windings (W1-W4) which are connected up to and disconnected from a DC voltage source (P;N) by the electrical device (E), and inductive overvoltage spikes which are coupled out from the said windings when the latter are disconnected.

3. Polarity reversal protection circuit arrangement according to at least one of the preceding claims, having a parallel circuit of more than one MOSFET transistor (TR) in the positive supply lead (LP).

## Revendications

1. Circuit de protection contre l'inversion de polarité pour un dispositif électrique (E), pouvant être raccordé à une source de tension continue (P;N) par l'intermédiaire d'une ligne d'alimentation positive (LP) et d'une ligne d'alimentation négative (LN), au moyen d'un transistor MOSFET à canal n (TR) qui fonctionne en sens inverse, qui est monté dans la ligne d'alimentation positive (LP) et qui peut être connecté dans le cas d'une polarisation correcte par le dispositif électrique (E), raccordé d'abord à la source de tension continue (P;N) par l'intermédiaire de la diode inverse du transistor MOSFET (TR), au moyen d'une tension de commande auxiliaire (UGH) qui est fournie à son électrode de grille (G) et qui est dérivée par une charge inductive branchée et débranchée par le dispositif électrique (E) et à partir des pointes de surtension de la charge inductive débranchée.

2. Circuit de protection contre l'inversion de polarité selon la revendication 1 avec des enroulements de moteur (W1 à W4) branchés par le dispositif électrique (E) à une source de tension continue (P;N) et débranchés de celle-ci et avec des pointes de surtension inductives extraites de ces enroulements lors de leur débranchement.

3. Circuit de protection contre l'inversion de polarité selon au moins l'une des revendications précédentes avec un circuit parallèle formé de plus d'un transistor MOSFET (TR) dans la ligne d'alimentation positive (LP).
